Europäisches Patentamt

European Patent Office

Office européen des brevets

(11) Numéro de publication: **0 269 775**
**A1**

## (12) DEMANDE DE BREVET EUROPEEN

(21) Numéro de dépôt: 86402675.2

(22) Date de dépôt: 02.12.86

(51) Int. Cl.⁴ **H01L 23/56** , H01H 85/04

(43) Date de publication de la demande:
08.06.88 Bulletin 88/23

(84) Etats contractants désignés:
**BE DE ES GB IT NL**

(71) Demandeur: **THOMSON-CSF**
**173, Boulevard Haussmann**
**F-75379 Paris Cédex 08(FR)**

(72) Inventeur: **Arnault, Pierre**
**Thomson-CSF SCPI 19, avenue de Messine**
**F-75008 Paris(FR)**

(74) Mandataire: **Benoit, Monique et al**
**THOMSON-CSF SCPI 19, avenue de Messine**
**F-75008 Paris(FR)**

(54) **Dispositif de protection contre la foudre par résistance fusible et sérigraphiée, procédé de fabrication, et application aux calculateurs embarqués à bord d'aéronefs.**

(57) Ce dispositif de protection électrique d'un nombre N déterminé de voies par résistance fusibles sérigraphiées permet de protéger des appareils contre les tensions de l'ordre de 115V par la fusion de la résistance, mais supporte des tensions beaucoup plus élevées (600V à 2000V) pendant des courtes durées, sans variations notables de la valeur ohmique de la résistance.

Il comporte un substrat (4) supportant pour chaque voie électrique deux éléments conducteurs (2, 3) à connecter entre eux et déposés par sérigraphie sur ledit substrat et une résistance fusible (1) déposée par sérigraphie et connectant les deux conducteurs entre eux. Le dispositif est caractérisé en ce que chaque résistance comporte deux couches (11, 12) distinctes et sérigraphiées séparément pour résister à des pointes de tension élevées pendant un instant de courte durée déterminée. Les conducteurs (2, 3) sont constitués d'une couche de pâte conductrice sérigraphiée, la connexion de la résistance (1) sur les conducteurs s'effectue par un contact de celle-ci sur presque toute la largeur des conducteurs.

Application pour la protection des calculateurs de bord des aéronefs.

FIG_1-B

## DISPOSITIF DE PROTECTION CONTRE LA FOUDRE PAR RESISTANCE FUSIBLE ET SERIGRAPHIEE, PROCEDE DE FABRICATION, ET APPLICATION AUX CALCULATEURS EMBARQUES A BORD D'AERONEFS

L'invention concerne la protection de matériel tels que des calculateurs de bord embarqués a bord des aéronefs qui doivent être protégés contre des pics de tension parasites dus a la foudre. Elle concerne également le procédé de fabrication d'un tel dispositif de protection.

Il est connu de protéger les calculateurs de bords en utilisant des résistances en carbone aggloméré dont l'intérêt est l'aptitude à supporter les pics de tension de grande amplitude mais de brève durée, plus exactement, des pics de 600 Volts pendant 100 microsecondes, ou encore des pics de 2000 Volts pendant 5 microsecondes, et ceci sans variation notable de leur valeur ohmique. Par ailleurs, ces résistances fondent dès l'instant qu'une tension de l'ordre de 115V leur est appliquée pendant plus de 100 millisecondes, ceci afin de protéger le calculateur au cas où il aurait été connecté inopinément sur le réseau de l'aéronef. Toutefois, pour résister aux pics élevés de tension, les résistances sont associées à des diodes écréteuses à temps de réponse très court.

Ces dispositifs s'avèrent trop encombrant et, selon l'invention, on se propose de réduire leurs dimensions.

D'autre part, en microélectronique hybride, on sait obtenir des dispositifs intégrant des barrettes de résistance avec des diodes écréteuses. Ces dispositifs sont relativement compacts, mais sont moins performants que ceux précédemment décrits et ils se présentent sous la forme d'un substrat supportant, pour chaque voie à protéger, des moyens d'écrétage telle qu'une ou deux diodes, selon si le dispositif est bidirectionnel ou non. Cette ou ces diodes sont connectées, d'une part à un potentiel de masse, et d'autre part à la tension d'alimentation. Sur cette dernière, un conducteur d'entrée et un conducteur de sortie sont sérigraphiés sur le substrat et reliés à une résistance elle-même sérigraphiée. Le tout est généralement recouvert d'un verre de protection. Les épaisseurs déposées dépendent principalement de l'épaisseur de résine déposée avant insolation sur l'écran métallique qui sert à la sérigraphie. On utilise habituellement des écrans en inox ayant de l'ordre de 200 mailles par pouce et une épaisseur d'émulsion de 15 microns. Le substrat utilisé est à base d'alumine. Les différentes phases de fabrication sont les suivantes:
-sérigraphie des conducteurs;
-séchage à 150° C et cuisson à 850°C;
-sérigraphie des résistances;
-séchage à 150°C, et cuisson à 850°C;
-sérigraphie du verre de protection;

-séchage à 150°C et cuisson a 550°C.

Le principal objet de l'invention est un dispositif de protection d'une pluralité de voies électriques contre la foudre par des résistances fusibles sérigraphiées comportant un substrat supportant pour chaque voie deux éléments conducteurs à connecter entre eux et déposés par sérigraphie sur le substrat, et une résistance déposée par sérigraphie connectant entre eux les deux conducteurs, caractérisé en ce que la résistance comporte deux couches distinctes superposées et sérigraphiées séparément. En concéquence, un deuxième objet de l'invention est un procédé de fabrication d'un tel dispositif pendant lequel les deux couches sont déposées l'une après l'autre par deux sérigraphies distinctes successives.

Un dernier objet de l'invention est l'application d'un tel dispositif pour la protection des calculateurs de bord embarqués sur les aéronefs.

L'invention et ces caractéristiques seront mieux comprises à la lecture de la description qui suit accompagnée des figures qui représentent respectivement:

-Figure 1A, 1B, et 1C, des vues représentatives de la structure du dispositif selon l'invention;

-Figure 2, un schéma électrique possible d'un dispositif selon l'invention;

-Figure 3, une vue relative à la structure du dispositif décrit à la figure 2;

-Figure 4, une vue déployée d'une réalisation possible d'un dispositif selon l'invention.

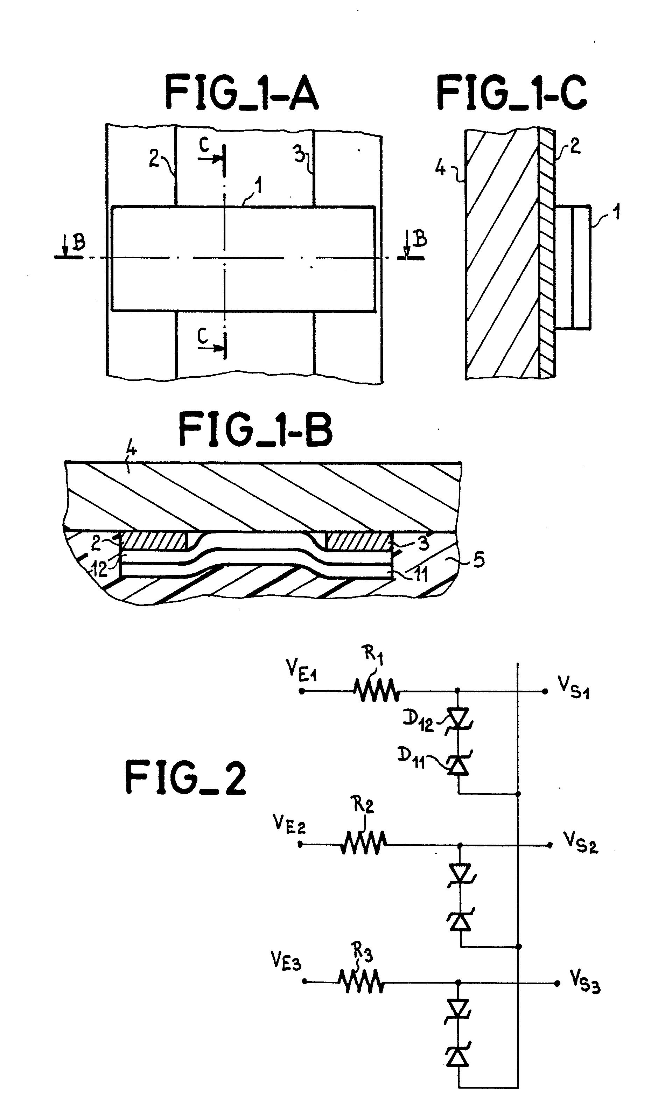

La figure 1A représente une résistance 1 connectant entre eux deux conducteurs 2 et 3 qui ont été représentés parallèles.

La figure 1B est une coupe selon l'axe BB de la figure 1a, et sur laquelle on a représenté un substrat 4 supportant les deux éléments et la résistance fusible.

Une caractéristique principale de l'invention est de réaliser la résistance 1 en deux couches 11 et 12. La résistance recouvre pratiquement complètement les deux éléments conducteurs et est plaquée au support entre les deux éléments conducteurs après son dépôt par sérigraphie. De manière générale il est préférable de protéger l'ensemble par un recouvrement par sérigraphie d'un verre ou d'une résine de protection 5.

On retrouve cette même structure superposée sur la figure 1c qui est une coupe de la figure 1a selon l'axe CC.

Les performances de cette structure sont améliorées par le fait que les contacts de la résistance 1 sur les éléments conducteurs 2 et 3 sont optimalisés. Ceci se traduit sur les figures par le fait que les résistances recouvrent les éléments conducteurs sur presque toute leur largeur. En effet, dans l'art antérieur les conducteurs étaient plus étroits et la résistance ne recouvrait ces conducteurs que sur la moitié de toute leur largeur. Les surfaces de contact étant alors insuffisante pour obtenir les résultats que l'invention vise à obtenir.

Dans l'art antérieur, les résistances sont monocouche et donc de faible épaisseur. L'augmentation de cette dernière dimension permet le passage d'un courant électrique plus important. Toutefois, c'est avec une structure à deux couches que la résistance trouve un rendement optimal.

Pour donner une idée un peu plus précise de la structure du dispositif selon l'invention, les dimensions qui suivent sont celles d'une réalisation du dispositif selon l'invention. Les éléments conducteurs ont une largeur de 0,8 millimètres au lieu de 0,5 millimètres dans l'art antérieur, faisant ainsi doubler la largeur de contact entre les conducteurs et la résistance. L'épaisseur des résistances a doublé et passe de l'ordre de 17 à 35 microns. Ces résistances peuvent supporter des pointes de tension atteignant 600V pendant 100 microsecondes ou même 2000V pendant 5 microsecondes, et ceci sans variation notable de leur valeur ohmique.

Le procédé de fabrication d'une telle structure est le suivant. La première opération consiste à sérigraphier les deux éléments conducteurs sur un substrat en alumine à 96%. Le matériau constituant les éléments conducteurs est de préférence une pâte conductrice à base d'or et de platine. Cette première sérigraphie est suivie d'un séchage à 150°C, puis d'une cuisson à 850°C.

Le deuxième opération consiste à sérigraphier la première couche résistive de la résistance. Le matériau utilisé est de préférence une pâte résistive à base d'oxyde de ruthénium. Cette deuxième sérigraphie est également suivie d'un séchage à 150°C, et d'une cuisson à 850°C.

La troisième opération consiste à sérigraphier la seconde couche résistive de la résistance de même dimension que la première couche et de même composition. Là aussi, cette opération est suivie d'un même séchage à 150°C et d'une cuisson à 850°C.

Pour terminer on procède à la sérigraphie du verre de protection sur l'ensemble, cette opération étant suivie d'un séchage à 150°C et d'une cuisson à 550°C.

L'ensemble constitué d'une résistance 1 et des deux conducteurs 2 et 3 constituent, lorsqu'il est fixé sur un substrat, un dispositif de protection électrique grâce à la résistance fusible. L'utilisation selon l'invention est destinée à protéger les calculateurs de bord des aéronefs. Dans ce but, il est utilisé pour réaliser un circuit électrique schématisé à la figure 2.

Sur cette dernière ce circuit consiste à protéger trois voies d'alimentation. Sur chaque voie on a placé une résistance, respectivement R1, R2 et R3. Chaque tension d'entrée $V_E$ est appliquée à la résistance par l'intermédiaire d'un des deux éléments conducteurs. La tension de sortie $V_S$ est recueillie à la sortie de la résistance sur le deuxième conducteur.

Comme dit précédemment, ces résistances supportent des pics de tension de l'ordre de 600V pendant 100 microsecondes. Mais ces pics de tension ne doivent pas être appliqués aux calculateurs. Dans ce but, on utilise pour chaque voie une ou deux diodes écréteuses connectées d'une part à la sortie de la résistance, et d'autre part à un potentiel de masse de référence $V_0$. Sur la figure 2 on a envisagé le cas d'un circuit bidirectionnel, c'est-à-dire que deux diodes écréteuses $D_{11}$ et $D_{12}$ sont montées tête bêche pour écréter les tensions positives aussi bien que les tensions négatives, et ceci pour chacune des voies.

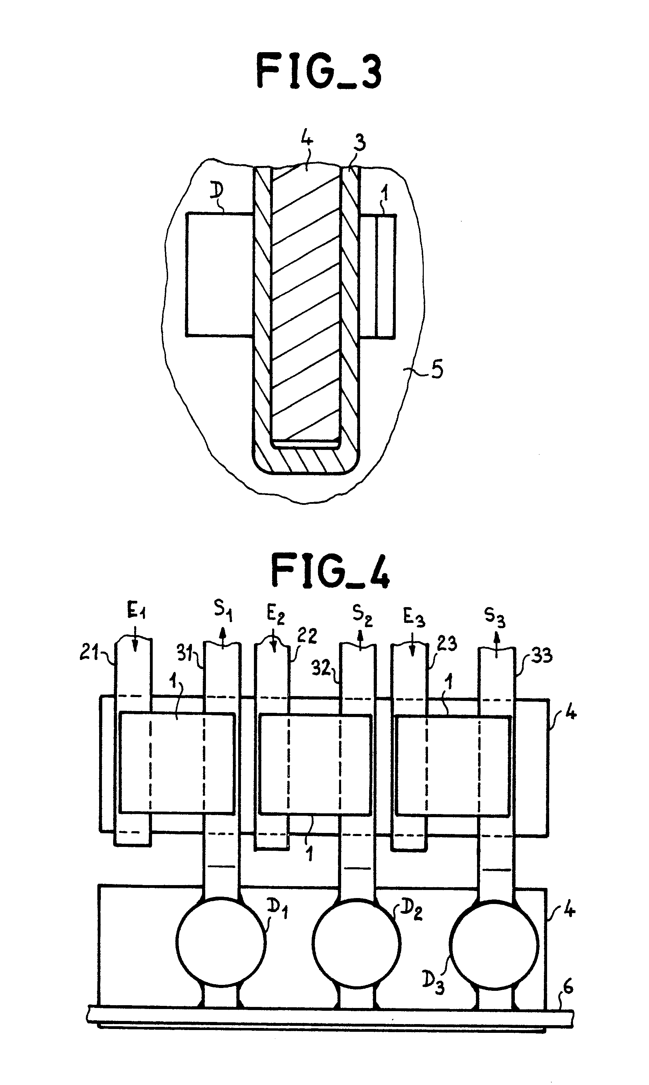

La figure 3 représente en coupe, de manière analogue à la figure 1C, la structure d'une réalisation selon l'invention. On y retrouve le substrat 4, la résistance en deux couches 1, un des deux conducteurs, par exemple 3. Ce conducteur contourne le substrat pour connecter une diode D placée de l'autre côté du substrat et qui peut être soit une des deux diodes représentées sur la figure 2 dans le cas d'un circuit bidirectionnel, soit la diode unique nécessaire pour une voie, dans le cas d'un circuit unidirectionnel. Le tout est recouvert d'une résine de protection 5.

La figure 4 représente, de manière très agrandie, un circuit à trois voies dans lequel on utilise trois fois le montage décrit aux figures 1A, 1B, 1C. On y retrouve trois conducteurs d'entrée 21, 22 et 23, et trois conducteurs de sortie 31, 32, 33. Tous sont déposés sur le substrat 4 représenté en deux parties, la vue étant déployée. Chaque paire de conducteurs est reliée à une résistance 1 par un montage analogue à celui décrit précédemment. Le deuxième conducteur de chaque montage contourne le substrat, de la même manière que celle représentée à la figure 3, pour se connecter à une diode. Sur cette figure une seule diode a été représentée par voie, ce pourrait être le cas pour un montage unidirectionnel, étant bien entendu que le circuit décrit à la figure 2 peut être réalisé de manière analogue, avec pour chaque voie un montage de deux diodes montées en tête bêche. Chaque diode est connectée d'autre part à un conducteur 6 relié à un potentiel de référence. Un tel circuit a une longueur d'environ 2cm. Le tout est enrobé d'une résine protectrice sérigraphiée.

## Revendications

1. Dispositif de protection d'une pluralité de voies électriques par résistance fusibles sérigraphiées, comportant un substrat (4) supportant pour chaque voie électrique :
-deux éléments conducteurs (2, 3) à connecter entre eux et déposés par sérigraphie sur ledit substrat ;
-une résistance fusible (1) déposée par sérigraphie et connectant entre eux les deux conducteurs ;
le dispositif étant caractérisé en ce que chaque résistance fusible comporte deux couches (11, 12) distinctes superposées et sérigraphiées séparément pour résister à des pointes de tension élevées pendant un instant de courte durée déterminé.

2. Dispositif de protection électrique selon la revendication 1, caractérisée en ce que les éléments conducteurs (2, 3) étant constitués d'une couche de pâte conductrice sérigraphiée, la connexion de la résistance (1) sur les éléments conducteurs s'effectue par un contact de celle-ci sur presque toute la largeur des conducteurs.

3. Dispositif de protection électrique selon la revendication 1 ou 2, caractérisé en ce que pour chaque voie, la résistance ($R1$, $R2$, $R3$) reçoit une tension d'entrée ($V_{E1}$, $V_{E2}$, $V_{E3}$) et délivre une tension de sortie ($V_{S1}$, $V_{S2}$, et $V_{S3}$), cette tension de sortie étant appliquée à l'une des deux électrodes d'une diode (D) dont la deuxième électrodes est connectée à un potentiel de référence ($V_0$) de manière à ce que les éventuelles pointes de tension élevée transmises par la résistance soient écrétées à partir d'une valeur déterminée.

4. Dispositif de protection électrique selon la revendication 1 ou 2, caractérisé en ce que pour chaque voie la résistance ($R1$, $R2$, $R3$) reçoit une tension d'entrée ($V_{E1}$, $V_{E2}$, $V_{E3}$) et délivre une tension de sortie ($V_{S1}$, $V_{S2}$, $V_{S3}$) cette tension de sortie étant appliquée à un montage de deux diodes ($D_{11}$ et $D_{12}$, $D_{21}$ et $D_{22}$) ($D_{31}$, $D_{32}$) montées tête bêche de manière à écréter les pointes de tension élevées transmises par la résistance, et pour constituer un circuit de protection bidirectionnel.

5. Dispositif selon la revendication 3 ou 4, caractérisé en ce que pour chaque voie, la connexion de deux éléments conducteurs (2, 3) à la résistance (1) se trouvant sur un premier côté du substrat (4), le deuxième conducteur (3) contourne le substrat pour connecter le montage de diodes ($D_1$, $D_2$, $D_3$) situées sur le deuxième côté du substrat.

6. Dispositif électrique de protection selon l'une quelconque des revendications précédentes, caractérisé en ce qu'une résine de protection (5) entoure l'ensemble du circuit.

7. Procédé de fabrication d'un circuit selon l'une quelconque des revendications précédentes, caractérisé en ce que la résistance ($1$, $R1$, $R2$, $R3$) est obtenue par la sérigraphie d'une première couche (11) suivie d'un séchage à 150°C et d'une cuisson à 850°C, puis de la sérigraphie d'une deuxième couche (12) elle-même suivie d'un séchage à 150°C et d'une cuisson à 850°C.

8. Utilisation d'un circuit selon l'une quelconque des revendications 1 à 6 pour la protection des calculateurs de bord embarqués à bord des aéronefs.

# FIG_1-A

# FIG_1-C

# FIG_1-B

# FIG_2

# FIG_3

# FIG_4

## DOCUMENTS CONSIDERES COMME PERTINENTS

| Catégorie | Citation du document avec indication. en cas de besoin. des parties pertinentes | Revendication concernée | CLASSEMENT DE LA DEMANDE (Int. Cl 4) |
|---|---|---|---|
| X | FR-A-2 478 369  (KNUDSEN) <br> * Figure 10; revendication 1; page 6, lignes 10-20; page 3, lignes 22-31 * | 1 | H 01 L  23/56 <br> H 01 H  85/04 |
| A | • | 6,7 | |
| | --- | | |
| A | FR-A-2 085 918  (RCA) <br> * Figures 1,2;  revendications 1,2,4;  page 1, lignes 6-10; page 3, lignes 12-19 * | 1,2 | |
| | --- | | |
| A | US-A-4 135 295  (ADAVANED MICRO) | | |
| | --- | | |
| A | FR-A-2 513 032  (CARRERAS) <br> * Revendications 1,6 * | 1,7 | DOMAINES TECHNIQUES RECHERCHES (Int. Cl. 4) |
| | --- | | |
| A | EP-A-0 025 347  (FUJITSU) <br> * Revendications 1,6 * | 1,6 | H 01 L <br> H 01 H |
| | --- | | |
| A | US-A-4 426 658  (SPRAGUE) <br> * Figure 1; revendication 1 * | 1,3 | |
| | --- | | |
| A | GB-A-1 467 631  (LUCAS) <br> * Revendication 1 * | 1,3 | |
| | ----- | | |

Le présent rapport de recherche a été établi pour toutes les revendications

| Lieu de la recherche | Date d'achèvement de la recherche | Examinateur |
|---|---|---|
| LA HAYE | 03-07-1987 | DE RAEVE R.A.L. |